Europäisches Patentamt

European Patent Office

Office européen des brevets

(11) Publication number: **0 057 520**
**B1**

(12) **EUROPEAN PATENT SPECIFICATION**

(45) Date of publication of patent specification: 01.04.87

(51) Int. Cl.⁴: **G 07 D 7/00, H 03 K 17/95**

(21) Application number: 82300197.9

(22) Date of filing: 14.01.82

(54) A device for detecting a magnetic strip embedded in paper.

(30) Priority: 16.01.81 JP 3893/81
03.06.81 JP 84314/81
29.06.81 JP 99619/81

(43) Date of publication of application:
11.08.82 Bulletin 82/32

(45) Publication of the grant of the patent:
01.04.87 Bulletin 87/14

(84) Designated Contracting States:
AT CH DE FR GB IT LI NL SE

(56) References cited:
EP-A-0 008 998
EP-A-0 021 350
DE-A-2 619 457
DE-A-2 834 287
DE-B-2 830 314
US-A-3 896 292

(73) Proprietor: Kabushiki Kaisha Toshiba
72, Horikawa-cho Saiwai-ku
Kawasaki-shi Kanagawa-ken 210 (JP)

(72) Inventor: Ishida, Tsuyoshi c/o Patent Division
Kabushiki Kaisha Toshiba 72, Horikawa-cho
Saiwai-ku Kawasaki-shi Kanagawa-ken 210 (JP)

(74) Representative: Kirk, Geoffrey Thomas et al
BATCHELLOR, KIRK & EYLES 2 Pear Tree Court
Farringdon Road
London EC1R 0DS (GB)

Courier Press, Leamington Spa, England.

## Description

This invention relates to a device for detecting a magnetic strip embedded in a sheet of paper such as a cheque or currency note.

Because of the excellent quality of copies produced by modern copying and printing machines, counterfeit currency notes, which are difficult to detect, are easily produced by using these machines. Countermeasures against such counterfeit notes have been devised in many countries and include embedding a metal strip in the paper note. A detecting device for automatically discriminating between genuine and counterfeit notes has been developed which detects the existence of the metal strip by utilising eddy-current loss, as shown in United Kingdom Patent Application No. 2017996. The eddy-current loss is represented as PC = K(dB/dt), (B = magnetic flux density, K = electrical conductivity = 1/ electrical resistance). The electrical resistance value of non-magentic metals is generally low, (e.g. Al is 2.65 $\mu\Omega$ cm; Cu is 1.7 $\mu\Omega$ cm). Since the conductivity (K) between magnetic metals and non-magnetic metals greatly varies, the sensitivity to non-magnetic metals (e.g. aluminium), is high due to its high eddy-current loss (Pc); the sensitivity to magnetic metals, (e.g. iron), however, is very low due to the low eddy-current loss (Pc). Therefore, the use of this prior art system in attempting to detect a magnetic metal strip has resulted in mis-detection or non-detection of the metal strip.

It is known from U.S. Patent No. 3896292A for a position coded key card to be detected by a detector which uses magnetoresistors. The magnetoresistors are connected as sensors and a change in the value of the resistors actuates a transistor. These changes are produced by the presence or absence of a piecè of magnetic material embedded in selected positions in the key card. The check for the validity of the key card is made with the card stationary with respect to the detector.

It is known from German Specification No. 2830314 for a checking device to include a pole shoe surrounded by an induction coil. When a credit card carrying a magnetic field generating means is drawn through the pole shoe, the magnetic field cuts the induction coil and generates a voltage therein.

An object of the present invention is to provide a device for detecting the presence of a strip of magnetic material embedded in a sheet of paper such as a currency note as the note is displaced along a path.

According to the present invention, a device for detecting the presence of a magnetic body embedded in a sheet of paper comprises magnetic field generating means and a magnetoresistor arranged in mutually fixed relation so that the resistance of the resistor depends upon the magnetic field from the generating means and means for determining the resistance variation of the resistor when the magnetic body causes the magnetic field at the resistor to be changed, characterised in that the magnetic body is in the form of a strip of elongate form and has a narrow width at right angles to its length, and means are provided for transporting said sheet of paper in the direction parallel to the width of the strip therein along a path, the path being disposed parallel to the widths of the magnetic field generating means and the magnetoresistor such that the passage of the strip along the path changes the magnetic field applied to the magnetoresistor.

The device of the present invention detects the presence of a magnetic strip in a paper currency note or the like without interference with the movement of the note. As the paper note is transported through the magnetic flux path, it is not interferred with by the detector.

In order that the invention may be more readily understood, it will now be described, by way of example only, with reference to the accompanying drawings, in which:—

Figure 1(a) is a plan view of a paper currency note having a strip of magnetic material embedded therein;

Figure 1(b) is a vertical sectional view of the note shown in Figure 1(a);

Figure 2(a) is a plan view of a detecting device according to the present invention;

Figure 2(b) is a side view of the detecting device shown in Figure 2(a);

Figure 3 is a block diagram of the electrical circuit of the detecting device shown in Figures 2(a) and 2(b);

Figures 4(a), 4(b) and 4(c) are signal waveform diagrams of each element shown in Figure 3;

Figure 5(a) is a plan view of another embodiment of a detecting device according to the present invention;

Figure 5(b) is a side view of the detecting device shown in Figure 5(a);

Figure 6(a) is a plan view of still another embodiment of a detecting device according to the present invention;

Figure 6(b) is a side view of the detecting device shown in Figure 6(a); and

Figure 7 is a block diagram of the electrical circuitry of the detecting device shown in Figures 6(a) and 6(b).

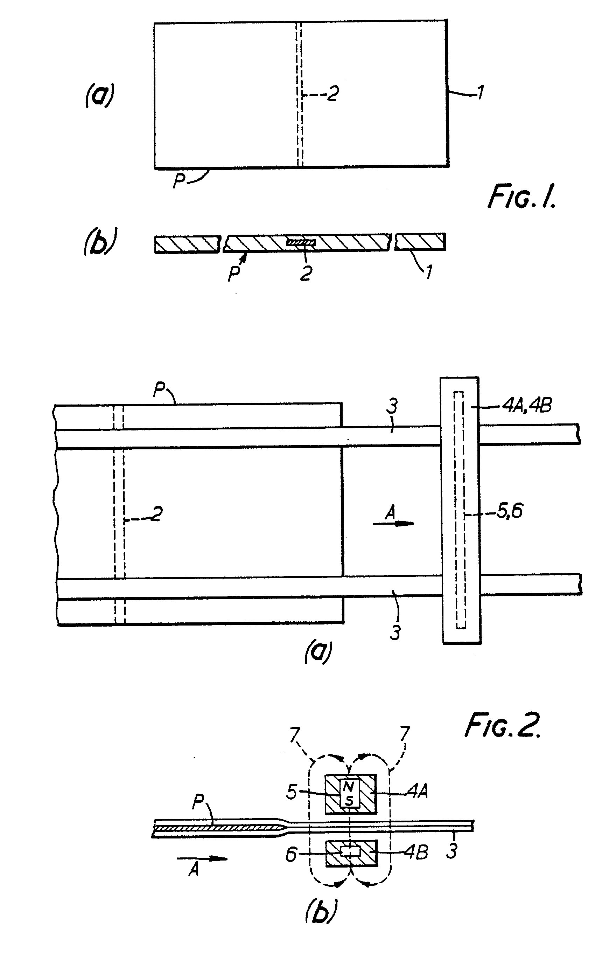

As shown in Figures 1(a) and 1(b), a currency note P comprises a generally rectangular sheet of paper 1 having an elongate strip 2 of magnetic material embedded in it. This magnetic strip 2 is made of a material such as iron, approximately 20 $\mu$m thick and approximately 0.5 to 1.0 mm wide. Its length is the same as the width of the paper 1. Magnetic strip 2 is positioned in note P such that the longitudinal axis of strip 2 extends in the widthwise direction of the note and in a direction perpendicular to the direction of the transportation path of the note.

As shown in Figures 2(a) and 2(b), note P is transported, in a direction indicated by arrow A, by two spaced transporting belts 3 between detecting heads 4A, 4B. Each belt consists of an upper and lower contacting belt which move in direction A. Note P is snugly held at each side between transporting belts 3. Positioned above and below belts 3 are a pair of aligned elongate detecting heads 4A and 4B. Detecting head 4A positioned above belt 3, comprises a generally rectangular body of a non-magnetic material, (e.g. vinyl chloride), and an elongate permanent magnet 5 embedded in the body. Detecting head 4B positioned below belt 3 comprises an elongated body of non-magnetic material, (e.g. vinyl chloride), and a narrow magnetic resistance element (magnetoresistor) 6 is embedded in the rectangular body. Permanent magnet 5 is made of ferrite and has a magnetic flux density of about 2K gauss. Magnetic resistance element 6 is made of a semiconductor composition InSb, and has a resistance value of approximately 200Ω. As shown, the longitudinal axis of permanent magnet 5 and magnetic resistance element 6 are positioned in a direction perpendicular to the transporting direction of note P.

Paper note P is then transported by belts 3 between, and without contact with, detecting heads 4A and 4B. As shown, permanent magnet 5 and resistance element 6 have an equal length which is greater than the length of magnetic strip 2. However, the widths of permenent magnet 5, element 6 and magnetic strip 2 are approximately equal. Permanent magnet 5 has its N—S polarity orientated so that its magnetic field cuts transporting path A and the surface of paper note P as it is transported betwen detecting heads 4A and 4B.

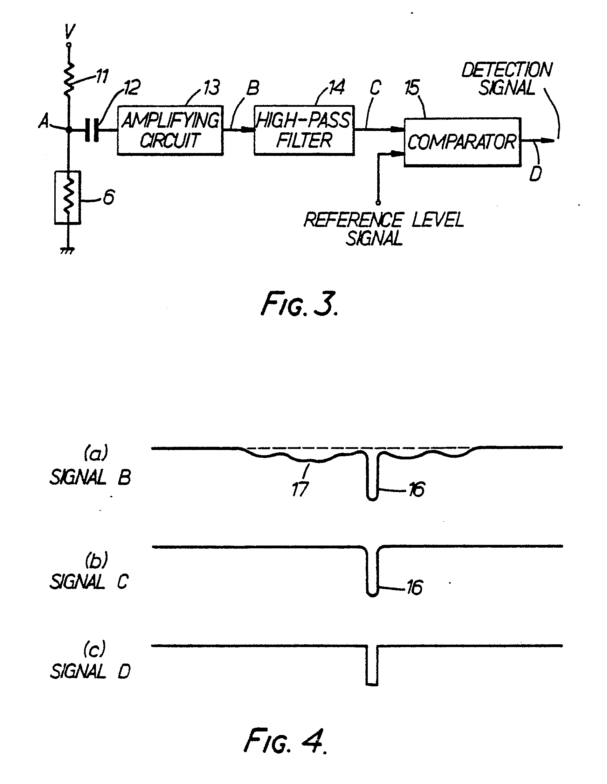

In Figure 3, one end of magnetic resistance element 6 is grounded while its other end is connected, via a resistance 11, to a DC power supply V. At the connecting point A of resistance element 6 and resistance 11, a voltage signal is obtained which varies according to the variation in resistance of resistance element 6. Point A is connected, via a capacitor 12, to the input terminal of an amplifying circuit 13. The output of amplifying circuit 13 is supplied to a high-pass filter 14. High-pass filter 14 comprises, for example, of a T-shaped circuit having a capacitor and a resistor; this filter passes only high frequency signals over 5K hertz from amplifying circuit 13. The output of filter 14 is then supplied to a comparator 15. Comparator 15, by comparing the output signal of filter 14 with a fixed reference level signal, converts the output signal of filter 14 into a binary signal.

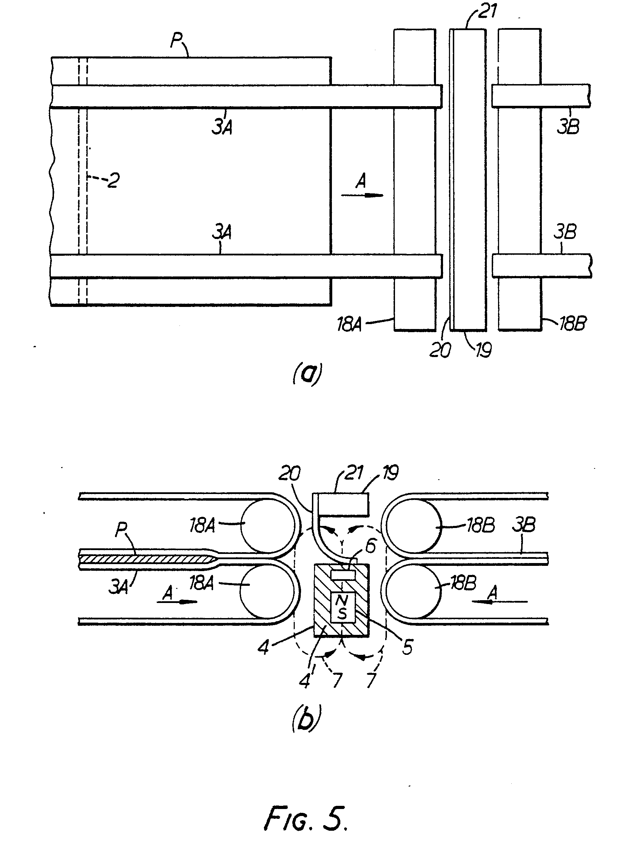

The detecting device operates as follows: When paper note P is not positioned between detecting heads 4A, 4B, magnetic resistance element 6 has a resistance of 200Ω caused by the uninterrupted magnetic field 7 of permanent magnet 5. If, however, paper note P, in which magnetic strip 2 is embedded, is transported between transporting heads 4A, 4B, magnetic field 7 will be attenuated causing the resistance of magnetic element 6 to decrease. Therefore, a temporary voltage variation will be produced at connection point A as strip 2 passes between the detecting heads. This voltage signal is then amplified by amplifying circuit 13, resulting in a signal B, as shown in Figure 4(a). Portion 16 of signal B represents the passage of the magnetic strip 2. Portion 17, a smaller amplitude change than portion 16, represents the presence of magnetic ink contained in a printed pattern on the paper note. Signal B, after filtering out the lower frequency components by highpass filter 14, results in signal C, as shown in Figure 4(b). As shown, signal C includes only the signal produced by metal strip P. Signal C is then supplied to comparator 15 wherein it is compared with a reference level signal and converted into a binary signal, is shown in Figure 4(c). This binary signal is then transmitted to a paper note discriminating device (not shown) for discriminating whether the note is genuine or counterfeit.

Another embodiment according to the present invention is shown in Figures 5(a) and 5(b). In this embodiment, paper note P is transported by belts 3A, 3A in direction A and then delivered, at a position between rollers 18A, 18B, to transporting belts 3B, 3B to continue its movement. Positioned between rollers 18A, 18B is a single detecting head 4 comprising permanent magnet 5 and magnetic resistance element 6. In this single detecting head, magentic resistance element 6 is located above, and aligned with, permanent magnet 5 in a housing 4' of non-magnetic material, (e.g. vinyl chloride). As with the detecting head of Figures 2(a) and 2(b), permanent magnet 5 has its N—S axis orientated so that it passes through the path A of note P. The path of note P is designed so that the note passes just above the upper surface of housing 4'. Spaced above detecting head 4 is a depressing mechanism 19 which depresses paper note P on to the upper surface of housing 4'. Depressing mechanism 19 consists of an elastic depressing arm 20 made of phosphor bronze and a stationary supporting member 21 to which one end of elastic arm 20 is secured. In this embodiment, paper note P is made to contact detecting head 4 by the depressing action of arm 20; as a result, inaccuracies in detection are precluded since the distance between each note and the resistance element is now constant. Variation in distance between the note and resistance element produces variations in the resistance of element 6 and erroneous results.

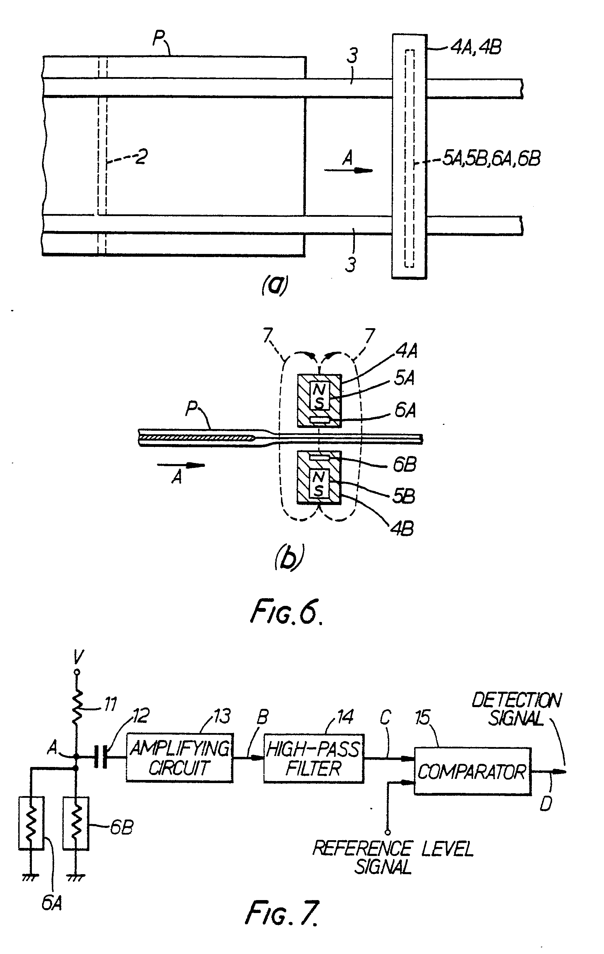

In still another embodiment of the invention, shown in Figures 6(a) and 6(b), each detecting head 4A, 4B comprises a respective permanent magnet 5A, 5B and an aligned magnetic resistance element 6A, 6B mounted in a body of non-magnetic material. Paper note P is transported between, and without contact with, spaced detecting heads 4A and 4B. Permanent magnets 5A, 5B have their N—S axis orientated so that it passes through the path A of note P. Consequently, their N—S polarity is orientated so that their magnetic fields 7 cut the transporting path A and surface of paper note P.

Figure 7 shows the electrical circuit for the detecting device shown in Figure 6. One end of each magnetic resistance element 6A, 6B is grounded, while the other end of the two elements are connected together at point A, via a resistance 11, to a power supply. At the connecting point A, a voltage signal is obtained which varies corresponding to the variation in resistance of magnetic resistance elements 6A, 6B. The output signal from point A is supplied to circuit elements which function in the same manner as previously described.

Since obvious changes may be made in the illustrated embodiment of the device without departing from the scope of the invention, it is intended that all matter contained herein be interpreted as illustrative only. For example, a coil can be utilised as a means for generating a magnetic field in lieu of a permanent magnet.

## Claims

1. A device for detecting the presence of a magnetic body (2) embedded in a sheet of paper (1), said device comprising magnetic field generating means (5) and a magnetoresistor (6) arranged in mutually fixed relation so that the resistance of the resistor (6) depends upon the magnetic field from the generating means and means (11—15) for determining the resistance variation of the resistor when the magnetic body causes the magnetic field at the resistor to be changed, characterised in that the magnetic body is in the form of a strip of elongate form and has a narrow width at right angles to its length, and means (3) are provided for transporting said sheet of paper in the direction parallel to the width of the strip therein along a path, the path being disposed parallel to the widths of the magnetic field generating means and the magnetoresistor such that the passage of the strip along the path changes the magnetic field applied to the magnetoresistor.

2. A device as claimed in claim 1, characterised in that said magnetic field generating means (5) is positioned on one side of said path and said magnetoresistor (6) is positioned on the other side of said path in alignment with said generating means.

3. A device as claimed in claim 1, characterised in that said magnetic field generating means (5A, 5B) and said magnetoresistor (6A, 6B) are adjacently positioned on one side of said path.

4. A device as claimed in claim 3, characterised in that said generating means and said magnetoresistor are contained within a housing (4A, 4B) of non-magnetic material.

5. A device as claimed in any preceding claim, characterised in that said generating means and said resistance means have lengths which are at least as long as said magnetic strip.

6. A device as claimed in any preceding claim, characterised in that said means for determining the resistance variation comprises a converting means (11, 12, 13) for converting the resistance variation of said resistor into an output signal; a filter (14), coupled to said converting means, for passing only the high-frequency components of said output signal; and a comparator means (15) for converting the output of said filter into a binary signal.

7. A device as claimed in claim 3, characterised in that the magnetic field generating means and the magnetoresistor are duplicated on the opposite side of said path, with the two generating means and the two magnetoresistors being arranged in mutually parallel spaced apart relation, and said determining means determine the resistance variation of both magnetoresistors.

8. A device as claimed in claim 7, characterised in that each magnetoresistor is positioned between the path and its associated magnetic field generating means.

## Patentansprüche

1. Einrichtung zur Feststellung des Vorhandenseins eines in einen Papierbogen (1) eingebetteten magnetischen Körpers (29) wobei die Einrichtung eine magnetfelderzeugende Einrichtung (5) und einen Magneto-Widerstand (6) aufweist, die in gegenseitig fester Beziehung angeordnet sind, so daß der Widerstand des Magneto-Widerstandes (6) vom Magnetfeld der magnetfelderzeugenden Einrichtung abhängt, sowie eine Einrichtung (11—15) zur Ermittlung der Widerstands änderung des Widerstandes, wenn der magnetische Körper eine Änderung des Magnetfeldes am Widerstand bewirkt, dadurch gekennzeichnet, daß der magnetische Körper in Form eines länglichen Streifens ausgebildet ist und rechtwinklig zu seiner Länge einer geringe Breite aufweist und daß Mittel (3) zum Transport des Blatt Papieres in einer parallel zur Breite des Streifens verlaufenden Richtung entlang einer Bahn vorgesehen sind, die parallel zur Breite der magnetfelderzeugenden Einrichtung und des Magneto-Widerstandes angeordnet ist, derart, daß beim Durchlauf des Streifens durch die Bahn das den Magneto-Widerstand beaufschlagende Magnetfeld geändert wird.

2. Einrichtung nach Anspruch 1, dadurch gekennzeichnet, daß die magnetfelderzeugende Einrichtung an der einen Seite der Bahn und der Magneto-Widerstand (6) auf der anderen Seite der Bahn in Ausrichtung mit der magnetfelderzeugenden Einrichtung angeordnet ist.

3. Einrichtung nach Anspruch 1, dadurch gekennzeichnet, daß die magnetfelderzeugende Einrichtung (5A, 5B) und der Magneto-Widerstand (6A, 6B) benachbart an einer Seite der Bahn angeordnet sind.

4. Einrichtung nach Anspruch 3, dadurch gekennzeichnet, daß die magnetfelderzeugende Einrichtung und der Magneto-Widerstand in einem Gehäuse (4A, 4B) aus nichtmagnetischem Material angeordnet sind.

5. Einrichtung nach einem der vorhergehenden, Ansprüche, dadurch gekennzeichnet, daß die magnetfelderzeugende Einrichtung und der Magneto-Widerstand eine Länge aufweisen, die wenigstens der Länge des Magnetstreifens entspricht.

6. Einrichtung nach einem der vorhergehenden, Ansprüche, dadurch gekennzeichnet, daß die Einrichtung zur Ermittlung der Widerstandsänderung einen Wandler (11, 12, 13) zum Umwandeln der Widerstandsänderung des Widerstandes in ein Ausgangssignal, ein mit dem Wandler verbundenes Filter (14) zum Durchlassen lediglich der hochfrequenten Teile des Ausgangssignales und einen Vergleicher (15) aufweist zum Umwandeln des Ausgangssignales des Filters in ein Binärsignal.

7. Einrichtung nach Anspruch 3, dadurch gekennzeichnet, daß auf der gegenüberliegenden Seite der Bahn eine weitere magnetfelderzeugende Einrichtung und ein weiterer Magneto-Widerstand angeordnet sind, wobei die beiden magnetfelderzeugenden Einrichtungen und die beiden Magneto-Widerstände in beabstandeter, paralleler Beziehung zueinander angeordnet, sind, und daß die Ermittlungseinrichtung die Widerstandsänderung beider Magneto-Widerstände ermittelt.

8. Einrichtung nach Anspruch 7, dadurch gekennzeichnet, daß jeder Magneto-Widerstand zwischen der Bahn und seiner zugeordneten magnetfelderzeugenden Einrichtung angeordnet ist.

**Revendications**

1. Dispositif pour détecter la présence d'un corps magnétique (2) encastré ou noyé dans une feuille de papier (I) qui comprend des moyens (5) engendrant un champ magnétique et une magnétorésistance (6) disposés dans des positions relatives fixes, de sorte que la valeur ohmique de la résistance (6) dépend de l'intensité du champ magnétique produit par lesmoyens (5) et des moyens (11—15) pour déterminer les variations de la valeur ohmique de ladite résistance quand le corps magnétique provoque une modification du champ magnétique s'exerçant sur ladite résistance, caractérisé en ce que le corps magnétique présente la forme d'une bande allongée et qui est étroite perpendiclairement à sa longueur, et en ce que des moyens (3) sont prévus pour transporter ladite feuille de papier dans une direction parallèle à la largeur de la bande qu'elle renferme, le long d'un trajet déterminé, ce trajet étant disposé parallèlement aux largeurs des moyens générant le champ magnétique et à la magnétorésistance, ce qui fait que le passage de ladite bande le long de ce trajet modifie le champ magnétique appliqué à la magnétorésistance.

2. Dispositif selon la revendication 1, caractérisé en ce que les moyens (5) générant le champ magnétique sont placés d'un côté dudit trajet, tandis que ladite magnétorésistance (6) est placée de l'autre côté dudit trajet, en alignement avec lesdits moyens de génération.

3. Dispositif selon la revendication 1, caractérisé en ce que les moyens (5A, 5B) générant ledit champ magnétique et ladite magnétorésistance (6A, 6B) sont disposés de manière adjacente du même côté dudit trajet.

4. Dispositif selon la revendication 3, caractérisé en ce que lesdits moyens de génération et ladite magnétorésistance sont logés dans une enveloppe (4A, 4B) en une matière non magnétique.

5. Dispositif selon l'une quelconque des revendications précédentes, caractérisé en ce que lesdits moyens de génération et ladite résistance ont des longueurs qui sont, au moins, égales à la longueur de ladite bande magnétique.

6. Dispositif selon l'une quelconque des revendications précédentes, caractérisé en ce que les moyens pour déterminer les variations de la valeur ohmique comprennent des moyens (11, 12, 13) pour convertir les variations de la valeur ohmique de ladite résistance en un signal de sortie, un filtre (14) couplé auxdits moyens de conversion, pour transmettre seulement les composantes de fréquence élevée dudit signal de sortie, et des moyens de comparaison (15) pour convertir ledit signal de sortie dudit filtre en un signal binaire.

7. Dispositif selon la revendication 3, caractérisé en ce que les moyens de génération du champ magnétique et la magnétorésistance sont doublés de l'autre côté dudit trajet, les deux moyens de génération et les deux magnétorésistances étant montés en parallèle avec un certain espacement mutuel, cependant que lesdits moyens de détermination déterminent les variations de la valeur ohmique des deux magnétorésistances.

8. Dispositif selon la revendication 7, caractérisé en ce que chaque magnétorésistance est placée entre ledit trajet et les moyens de génération de champ magnétique correspondants.

*(a)*

P

2

1

**FIG. 1.**

*(b)*

P  2  1

P  3  4A,4B

2  A  5,6

3

*(a)*

**FIG. 2.**

7  7

5  N S  4A

P

6  4B  3

A

*(b)*

*Fig. 3.*

*Fig. 4.*

(a)

(b)

Fig. 5.

(a)

(b)

FIG.6.

DETECTION SIGNAL

REFERENCE LEVEL SIGNAL

FIG.7.